# EUROPEAN PATENT APPLICATION

(11) **EP 4 712 731 A1**
(43) Date of publication of application: **18.03.2026**
(21) Application number: 25201941.9
(22) Date of filing: 12.09.2025
(51) Int. Cl.: H10D 89/60, H02H 9/04

(54) **LOW LEAKAGE ESD PROTECTION**

(30) Priority: 12.09.2024 US 202463693979 P; 14.01.2025 US 202563745008 P; 08.08.2025 US 202519295019
(71) Applicant: QORVO US, INC., Greensboro, NC 27409 (US)
(72) Inventor: BAND, Theo, Greensboro, NC 27409 (US); KUENEN, Jeroen Cornelis, Greensboro, NC 27409 (US)
(74) Representative: D Young & Co LLP

(57) **Abstract**

The present disclosure relates to electrostatic discharge (ESD) protection circuitry of an electronic device, which is capable of protecting thin-oxide metal-oxide-semiconductor (MOS) transistors within the electronic device during an ESD event and/or a power-on transient stage without large current leakage. The disclosed ESD protection circuitry at least includes a protection switch and a switch controller. The protection switch is coupled between an external pin of the electronic device and internal circuitry of the electronic device, which is composed of thin-oxide MOS transistors. The switch controller is configured to control the protection switch to be conducting or non-conducting based on both a status of a first voltage supply powering the ESD protection block and a presence of an ESD event at the external pin, such that the external pin is electrically connected to or disconnected from the internal circuitry.

## Description

### Related Applications

This application claims the benefit of provisional patent application serial number 63/693,979, filed September 12, 2024,e and provisional patent application serial number 63/745,008, filed January 14, 2025, the disclosures of which are hereby incorporated herein by reference in their entireties.

### Field of the Disclosure

The present disclosure relates to electrostatic discharge (ESD) protection circuitry of an electronic device, which is capable of protecting thin-oxide metal-oxide-semiconductor (MOS) transistors within the electronic device during an ESD event and/or a power-on transient stage without large current leakage.

### Background

With the increasing popularity of smart devices and portable electronic devices, high speed and compact transistors are highly desired. Compared to conventional metal-oxide-semiconductor (MOS) transistors, thin-oxide MOS transistors offer significantly increased switching speed and higher current density and allow more densely integrated circuits, leading to improved performance in high-speed applications. However, these advantages benefiting from the thin oxide layer are often accompanied by an increased breakdown risk during an electrostatic discharge (ESD) event that involves a temporary high voltage experienced by the device.

To prevent the thin-oxide MOS transistors inside the devices from breaking down during the ESD event, a clamp cell fabricated with thin-oxide, which limits the voltage to a safe level for all circuitry behind it, is typically applied between an external pin of the device and internal circuitry composed of the thin-oxide MOS transistors. One major challenge of existing thin-oxide clamp cells is their large leakage currents. For applications that require a large number of thin-oxide clamp cells, a total leakage current can become substantial, which will significantly impact the electronic performance of the devices.

The inventors of the presently described techniques have recognized that it may be appropriate to provide improved ESD protection circuitry, which is capable of protecting the thin-oxide MOS transistors within the devices during the ESD event without causing excessive current leakage from the devices.

### Summary

Particular aspects are set out in the appended independent claims. Various optional embodiments are set out in the dependent claims.

The present disclosure relates to electrostatic discharge (ESD) protection circuitry of an electronic device, which is capable of protecting thin-oxide metal-oxide-semiconductor (MOS) transistors within the electronic device during an ESD event and/or a power-on transient stage without large current leakage. The disclosed ESD protection circuitry at least includes a protection switch and a switch controller. The protection switch is coupled between an external pin of the electronic device and internal circuitry of the electronic device. The switch controller is configured to control the protection switch to be conducting or non-conducting based on both a status of a first voltage supply powering the ESD protection block and a presence of an ESD event at the external pin. Herein, the internal circuitry has a lower breakdown voltage than that of the protection switch and the switch controller. The switch controller is configured to control the protection switch to be non-conducting when the first voltage supply is absent, when the first voltage supply is in a power-on transient stage, or when an ESD event occurs at the external pin and/or in association with the first voltage supply, such that the external pin is electrically disconnected from the internal circuitry. Additionally, the switch controller is configured to control the protection switch to be conducting when the first voltage supply powering the ESD protection block is stably present and no ESD event occurs at the external pin or in association with the first voltage supply, such that the external pin is electrically connected to the internal circuitry.

In one embodiment of the ESD protection circuitry, the internal circuitry includes a number of thin-oxide metal-oxide-semiconductor (MOS) transistors. The protection switch and the switch controller are fabricated with thick oxide, rather than thin oxide as used in the thin-oxide MOS transistors within the internal circuitry.

According to one embodiment, the ESD protection circuitry further includes an ESD clamp cell, which is coupled between the external pin and ground and before the protection switch and the switch controller. Herein, the ESD clamp cell is configured to limit a voltage level at the external pin below the breakdown voltage of the protection switch and the switch controller. The ESD clamp cell is fabricated with thick oxide, rather than thin oxide as used in the thin-oxide MOS transistors within the internal circuitry.

In one embodiment of the ESD protection circuitry, the protection switch is implemented by a protection transistor that is an N-type MOS transistor. A drain of the protection transistor is coupled to the external pin, a source of the protection transistor is coupled to the internal circuitry, and a gate of the protection transistor is controlled by the switch controller.

In one embodiment of the ESD protection circuitry, the switch controller includes an inverter, a first capacitor, a control switch, and a second capacitor. The inverter is coupled between the first voltage supply powering the ESD protection block and ground, and the first capacitor is coupled between the first voltage supply and an input terminal of the inverter. The control switch is coupled between the gate of the protection transistor and ground, an output terminal of the inverter is coupled to the gate of the protection transistor, and the second capacitor is coupled between the external pin and a controlling terminal of the control switch.

In one embodiment of the ESD protection circuitry, the inverter is implemented by a first transistor and a second transistor, where the first transistor is a P-type MOS transistor, and the second transistor is an N-type MOS transistor. A source of the first transistor is coupled to the first voltage supply, a gate of the first transistor is coupled to a gate of the second transistor forming the input terminal of the inverter, a drain of the first transistor is coupled to a drain of the second transistor forming the output terminal of the inverter, and a source of the second transistor is coupled to ground. The control switch is implemented by a control transistor that is an N-type MOS transistor, where a drain of the control transistor is coupled to the gate of the protection transistor, a source of the control transistor is coupled to ground, and a gate of the control transistor is coupled to the external pin through the second capacitor. The control transistor is larger than the first transistor of the inverter. When the first voltage supply is absent, the inverter is inactive, and a voltage level at the output terminal of the inverter is low. In this state, regardless of whether an ESD event occurs at the external pin or not, the protection transistor is non-conducting, and thereby electrically disconnects the internal circuitry from the external pin. During the short power-on transient stage of the first voltage supply or when an ESD event occurs in association with the first voltage supply, the first capacitor pulls a voltage level at the input terminal of the inverter high, which leads the voltage level at the output terminal of the inverter to be low. In this state, regardless of whether an ESD event occurs at the external pin or not, the protection transistor is non-conducting, and thereby electrically disconnects the internal circuitry from the external pin. When the first voltage supply is stably present and an ESD event occurs at the external pin, the second capacitor pulls a voltage level at the gate of the control transistor high, which makes the control transistor conduct to ground. In this state, the output terminal of the inverter and the gate of the protection transistor are pulled to a low voltage level through the conducting control transistor, which is larger than the first transistor of the inverter. When the first voltage supply is stably present and no ESD event occurs at the external pin or in association with the first voltage supply, the control transistor is non-conducting, and the voltage level of the output terminal of the inverter is high, such that the protection transistor is conducting, and the external pin is electrically connected to the internal circuitry.

In one embodiment of the ESD protection circuitry, the first transistor, the second transistor, the control transistor, and the protection transistor are fabricated with thick oxide, rather than thin oxide as used in the thin-oxide MOS transistors within the internal circuitry. The first voltage supply powering the ESD protection block is larger than a voltage input applied to the internal circuitry.

In one embodiment of the ESD protection circuitry, the switch controller further includes a first resistor and a second resistor. Herein, the first resistor is coupled between the input terminal of the inverter and ground, and the second resistor is coupled between the gate of the control transistor and ground.

According to one embodiment, an electronic device at least includes an external pin, internal circuitry, and an ESD protection block coupled between the external pin and the internal circuitry. Herein, the internal circuitry includes a number of thin-oxide MOS transistors, and the ESD protection block is fabricated with thick oxide, rather than thin oxide as used in the thin-oxide MOS transistors within the internal circuitry, such that the internal circuitry has a lower breakdown voltage than that of the ESD protection block. The ESD protection block is configured to connect the external pin to or disconnect the external pin from the internal circuitry based on both a status of a first voltage supply powering the ESD protection block and a presence of an ESD event at the external pin. The external pin is electrically disconnected from the internal circuitry when the first voltage supply is absent, when the first voltage supply is in a power-on transient stage, or when an ESD event occurs at the external pin and/or in association with the first voltage supply. Additionally, the external pin is electrically connected to the internal circuitry when the first voltage supply powering the ESD protection block is stably present and no ESD event occurs at the external pin or in association with the first voltage supply.

In one embodiment of the electronic device, the ESD protection block at least includes a protection switch coupled between the external pin and the internal circuitry, and a switch controller configured to control the protection switch to be conducting or non-conducting based on both the status of the first voltage supply powering the ESD protection block and the presence of an ESD event at the external pin. The switch controller is configured to control the protection switch to be non-conducting when the first voltage supply is absent, when the first voltage supply is in a power-on transient stage, or when an ESD event occurs at the external pin and/or in association with the first voltage supply, such that the external pin is electrically disconnected from the internal circuitry. Additionally, the switch controller is configured to control the protection switch to be conducting when the first voltage supply powering the ESD protection block is stably present and no ESD event occurs at the external pin or in association with the first voltage supply, such that the external pin is electrically connected to the internal circuitry.

In one embodiment of the electronic device, the ESD protection block further includes an ESD clamp cell, which is coupled between the external pin and ground and before the protection switch and the switch controller. Herein, the ESD clamp cell is configured to limit a voltage level at the external pin below a breakdown voltage of the protection switch and the switch controller.

In one embodiment of the electronic device, the external pin is configured to provide a second voltage supply for the electronic device to power the internal circuitry, and the second voltage supply is lower than the first voltage supply powering the ESD protection block.

In one embodiment of the electronic device, the external pin is configured to provide a logic input signal for the internal circuitry, and the logic input signal for the internal circuitry is lower than the first voltage supply powering the ESD protection block.

According to one embodiment, the electronic device further includes a low dropout regulator (LDO), which is coupled between the first voltage supply and the internal circuitry. Herein, the internal circuitry is powered by a regulated version of the first voltage supply provided through the LDO.

According to one embodiment, the electronic device further includes a clamp cell coupled between the first voltage supply and ground and before the LDO. Herein, the clamp cell is configured to clamp a voltage level applied to the LDO below a breakdown voltage of the LDO during the power-on transient stage of the first voltage supply.

In one embodiment of the electronic device, the LDO and the clamp cell are fabricated with thick oxide, rather than thin oxide as used in the thin-oxide MOS transistors within the internal circuitry, such that the internal circuitry has a lower breakdown voltage than that of the LDO and the clamp cell.

According to one embodiment, a method of operations of an ESD protection block of an electronic device is described, aimed at protecting thin-oxide MOS transistors within internal circuitry of the electronic device. The ESD protection block includes a switch controller and a protection switch coupled between an external pin of the electronic device and the internal circuitry. The method of the operations of the ESD protection block includes disconnecting the external pin from the internal circuitry by opening the protection switch when a first voltage supply powering the ESD protection block is absent, disconnecting the external pin from the internal circuitry by opening the protection switch during a power-on transient stage of the first voltage supply powering the ESD protection block, and disconnecting the external pin from the internal circuitry by opening the protection switch when an ESD event occurs at the external pin and/or in association with the first voltage supply. Additionally, the method of the operations of the ESD protection block further includes connecting the external pin to the internal circuitry by closing the protection switch when the first voltage supply powering the ESD protection block is stably present and no ESD event occurs at the external pin or in association with the first voltage supply. Herein, the opening or closing of the protection switch is controlled by the switch controller based on both the status of the first voltage supply and the presence of the ESD event at the external pin. The thin-oxide MOS transistors within internal circuitry have a lower breakdown voltage than that of the protection switch and the switch controller.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of various embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates an example schematic of a portion of an electronic device including an electrostatic discharge (ESD) protection block according to some embodiments of the present disclosure.
Figure 2 illustrates an example schematic of an alternative portion of the electronic device including the ESD protection block according to some embodiments of the present disclosure.
Figure 3 illustrates an example implementation of a switch controller within the ESD protection block according to some embodiments of the present disclosure.
Figure 4 illustrates a flowchart of operations of the ESD protection block to protect thin-oxide metal-oxide-semiconductor (MOS) transistors within the electronic device according to some embodiments of the present disclosure.

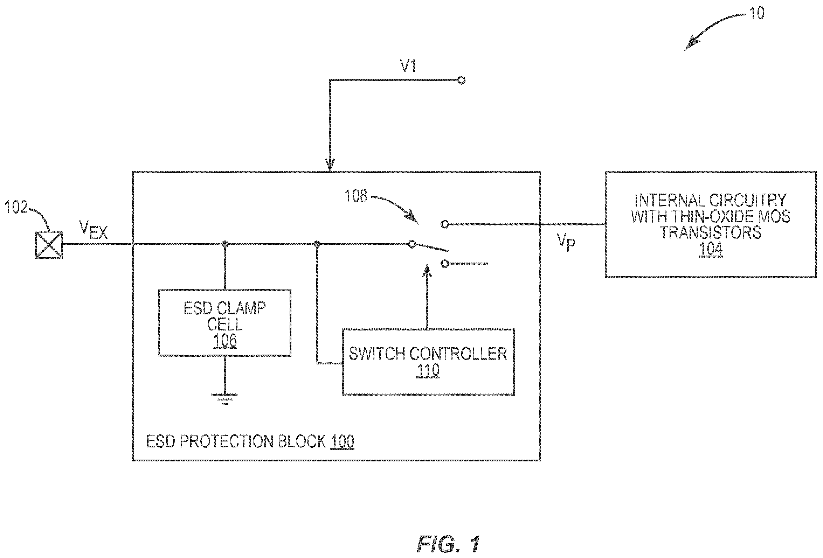

It will be understood that for clear illustrations, Figures 1-4 may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure relates to electrostatic discharge (ESD) protection circuitry of an electronic device, designed to protect thin-oxide metal-oxide-semiconductor (MOS) transistors within the electronic device during an ESD event, which involves a temporary high voltage experienced by the electronic device, and/or a power-on transient stage of the electronic device. The disclosed ESD protection circuitry combines the capability of conducting an abnormally high current (e.g., ESD current or power-on transient current) while maintaining a low leakage current for the electronic device.

Figure 1 illustrates a simplified schematic of a portion of an electronic device 10 that includes an ESD protection block 100 electrically coupled between an external pin 102 and internal circuitry 104 of the electronic device 10. In practical applications, the electronic device 10 may include multiple external pins (similar to the external pin 102) and multiple ESD protection blocks (similar to the ESD protection block 100), each of which is coupled between a corresponding external pin and the internal circuitry 104 (not shown). These ESD protection blocks constitute ESD protection circuitry of the electronic device 10.

The internal circuitry 104 may be composed of thin-oxide MOS transistors (not shown), which provide superior fast switching speed and high current density but are accompanied by a relatively low breakdown voltage. Typically, a temporary high voltage experienced by the electronic device 10 in an ESD event occurs at the external pins of the electronic device 10 (such as the external pin 102). If the external pin 102 is directly connected to the internal circuitry 104 (without the ESD protection block 100), the internal circuitry 104 will also experience the temporary high voltage during the ESD event, resulting in breakdown damage to the thin-oxide MOS transistors within the internal circuitry 104. The proposed ESD protection block 100 is configured to limit a voltage applied to the internal circuitry 104 to a safe voltage level (e.g., 0.8V) of each thin-oxide MOS transistor within the internal circuitry 104, while ensuring a relatively low leakage current.

In some applications, the external pin 102 may be configured to provide a voltage input V_{EX} to the internal circuitry 104. The voltage input V_{EX} may serve as a second voltage supply for the electronic device 10 to power the internal circuitry 104 or as a logic input signal for the internal circuitry 104. The ESD protection block 100 is configured to ensure that only a protected/safe version V_{P} of the voltage input V_{EX} can be applied to the internal circuitry 104, so as to prevent electronic damage to the thin-oxide MOS transistors within the internal circuitry 104.

In detail, the ESD protection block 100 includes an ESD clamp cell 106 coupled between the external pin 102 and ground, a protection switch 108 coupled between the external pin 102 and the internal circuitry 104, and a switch controller 110 configured to control the protection switch 108 to be conducting or non-conducting at least based on the voltage input V_{EX} provided at the external pin 102. The ESD protection block 100 is powered by a first voltage supply V1, which might be either an internal power supply integrated within the electronic device 10 or an external power supply provided from outside the electronic device 10.

Note that if the voltage input V_{EX} provided at the external pin 102 is the second voltage supply for powering the internal circuitry 104, the voltage input V_{EX} and the first voltage supply V1 provided to the ESD protection block 100 are two different power sources. The voltage input V_{EX} and the first voltage supply V1 are provided through two different supply rails (not shown) within the electronic device 10, one of which is for the high-speed thin-oxide MOS transistors (e.g., within the internal circuitry 104) and the other one of which is for low standby power and interfacing circuitry (e.g., the ESD protection block 100 with the thick-oxide elements).

The first voltage supply V1 might be a battery power supply. If the ESD protection block 100 exhibits a relatively large leakage current, the battery may undesirably drain quickly. To achieve the low leakage current, the ESD clamp cell 106, the protection switch 108, and the switch controller 110 are fabricated with thick oxide, rather than thin oxide as used in the thin-oxide MOS transistors within the internal circuitry 104. However, due to the thick oxide, the ESD clamp cell 106 cannot ensure that its clamp voltage is as low as the breakdown voltage of the thin-oxide MOS transistors within the internal circuitry 104. Therefore, the ESD clamp cell 106 alone, without being combined with the protection switch 108 and the switch controller 110, cannot efficiently protect the thin-oxide MOS transistors within the internal circuitry 104. The clamp voltage of the ESD clamp cell 106 is too high to be safely applied to the thin-oxide MOS transistors within the internal circuitry 104. Herein, in fact, the ESD clamp cell 106 is configured to protect the protection switch 108 and the switch controller 110, rather than protecting the thin-oxide MOS transistors within the internal circuitry 104 during an ESD event. The clamp voltage of the ESD clamp cell 106 is low enough (e.g., lower than the breakdown voltage of the protection switch 108 and the switch controller 110) to be safely applied to the thick-oxide protection switch 108 and the thick-oxide switch controller 110. During the ESD event, the protection switch 108 and the switch controller 110 are configured to protect the internal circuitry 104 by disconnecting the internal circuitry 104 from the external pin 102, thereby preventing the thin-oxide MOS transistors within the internal circuitry 104 from experiencing the abnormally high voltage (more details are described in subsequent paragraphs). In addition, due to the thick oxide, the first voltage supply V1 that powers the ESD protection block 100 is higher than the protected/safe version V_{P} of the voltage input V_{EX} applied to the thin-oxide MOS transistors in the internal circuitry 104 (e.g., the first voltage supply V1 is about 3 V, while the protected/safe voltage V_{P} is about 0.8V).

When the first voltage supply V1 is absent, the protection switch 108 of the ESD protection block 100 is controlled (by the switch controller 110) to be non-conducting (i.e., the protection switch 108 is open). As a result, regardless of the voltage level at the external pin 102, the external pin 102 is always electrically disconnected from the internal circuitry 104, and no voltage input will be provided to the internal circuitry 104. During a power-on transient stage of the first voltage supply V1, the protection switch 108 of the ESD protection block 100 is controlled (by the switch controller 110) to be non-conducting. As a result, regardless of the voltage level at the external pin 102, the external pin 102 remains disconnected from the internal circuitry 104, and no voltage input will be provided to the internal circuitry 104. When an ESD event occurs in association with the first voltage supply V1, the protection switch 108 of the ESD protection block 100 is controlled (by the switch controller 110) to be non-conducting (i.e., the protection switch 108 is open). As a result, regardless of the voltage level at the external pin 102, the external pin 102 is always electrically disconnected from the internal circuitry 104, and no voltage input will be provided to the internal circuitry 104.

When the first voltage supply V1 is stably present without associating with any ESD event, the protection switch 108 of the ESD protection block 100 is controlled (by the switch controller 110) to be either conducting or non-conducting based on the transient voltage level presented at the external pin 102. When the first voltage supply V1 is stably present and the transient voltage level presented at the external pin 102 exceeds the breakdown voltage of the thin-oxide MOS transistors (i.e., an ESD event occurs at the external pin 102), the switch controller 110 is configured to make the protection switch 108 non-conducting. As a result, the abnormally high transient voltage level presented at the external pin 102 will not reach the internal circuitry 104. In addition, in some scenarios where the transient voltage level presented at the external pin 102 exceeds the breakdown voltage of the protection switch 108 or the switch controller 110, the ESD clamp cell 106 is configured to clamp the abnormally high transient voltage level presented at the external pin 102 to a safe level for the protection switch 108 and the switch controller 110. As a result, the ESD event occurring at the external pin 102 will not damage the protection switch 108 or the switch controller 110. Furthermore, when the first voltage supply V1 is stably present and the voltage input V_{EX} provided at the external pin 102 is stable and does not exceed the breakdown voltage of the thin-oxide MOS transistors (i.e., no ESD event occurs at the external supply pin 102), the switch controller 110 is configured to make the protection switch 108 conducting (i.e., the protection switch 108 is closed). As a result, the external pin 102 will be electrically connected to the internal circuitry 104, and the voltage input V_{EX} (e.g., about 0.8 V), which is provided by the external pin 102 and monitored by the switch controller 110, will be applied to the internal circuitry 104.

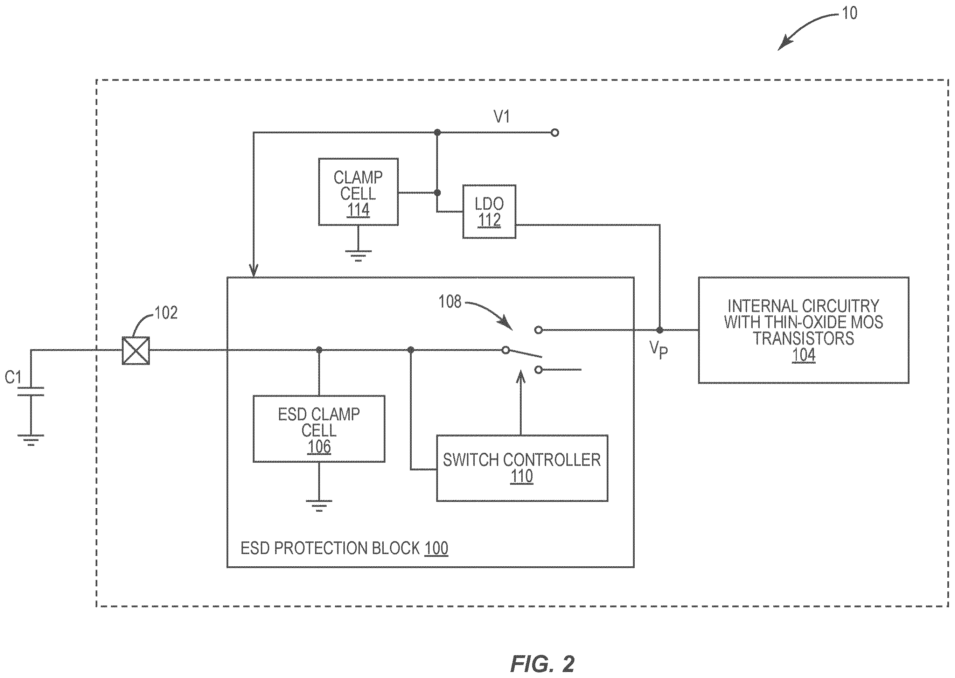

In some applications, as illustrated in Figure 2, the internal circuitry 104 may be powered by a regulated version of the first voltage supply V1, which is provided through a low dropout regulator (LDO) 112, instead of by a separate voltage supply provided at the external pin 102. Herein, the LDO 112 is coupled between the first voltage supply V1 and the internal circuitry 104, and the LDO 112 is configured to regulate the first voltage supply V1 to the safe voltage level V_{P} suitable for the internal circuitry 104 (e.g., lower than the breakdown voltage of the thin-oxide MOS transistors within the internal circuitry 104). The LDO 112 is also fabricated with thick oxide, rather than thin oxide as used in the thin-oxide MOS transistors within the internal circuitry 104. As such the LDO 112 can tolerate a higher voltage level (e.g., the first voltage supply V1) than the internal circuitry 104. In one embodiment, the electrical device 10 may further include another clamp cell 114 coupled between the first voltage supply V1 and ground and before the LDO 112. The clamp cell 114 is also fabricated with thick oxide and configured to protect the LDO 112 during the power-on transient stage of the first voltage supply V1 (e.g., the clamp cell 114 is configured to clamp a voltage level applied to the LDO 112 below a breakdown voltage of the LDO 112 during the power-on transient stage of the first voltage supply V1). The clamp cell 114 may be implemented the same as the ESD clamp cell 106.

Typically, an LDO needs a capacitor (coupled between an output of the LDO and ground) to stabilize its output signal. However, due to the relatively large physical size of the stabilizing capacitor, it is not desirable to integrate the stabilizing capacitor in a same device as the LDO. For the purpose of this illustration, a stabilizing capacitor C1 for the LDO 112 is not integrated into the electrical device 10 but connected to the electrical device 10 at the external pin 102. The external pin 102 is electrically connected to the output of the LDO 112, such that the stabilizing capacitor C1 is capable of stabilizing the output signal (i.e., stabilizing the safe voltage supply V_{P} to the internal circuitry 104). Herein, although the external pin 102 is not configured to provide any voltage input to the internal circuitry 104, the external pin 102 may still experience ESD events. If the external pin 102 is directly connected to the output of the LDO 112, which is directly connected to the internal circuitry 104, the internal circuitry 104 will experience the temporary high voltage during the ESD event, resulting in breakdown damage to the thin-oxide MOS transistors within the internal circuitry 104. Therefore, the ESD protection block 100 is still deployed between the external pin 102 and the output of the LDO 112/the internal circuitry 104.

Similar to the description above, when the first voltage supply V1 is absent, the protection switch 108 of the ESD protection block 100 is controlled (by the switch controller 110) to be non-conducting (i.e., the protection switch 108 is open). As a result, regardless of whether an ESD event occurs at the external pin 102, the external pin 102 is always disconnected from the internal circuitry 104. In addition, when the first voltage supply V1 is absent, the LDO 112 is inactive, and no voltage supply will be provided to the internal circuitry 104. During a power-on transient stage of the first voltage supply V1, the protection switch 108 of the ESD protection block 100 is controlled (by the switch controller 110) to be non-conducting. As a result, regardless of the voltage level at the external pin 102, the external pin 102 remains disconnected from the internal circuitry 104. In addition, during the power-on transient stage of the first voltage supply V1, the clamp cell 114 is configured to clamp the transient voltage level of the first voltage supply V1 to a safe level for the LDO 112, and the LDO 112 is activated and configured to provide the protected/safe voltage V_{P} to power the internal circuitry 104. When an ESD event occurs in association with the first voltage supply V1, the protection switch 108 of the ESD protection block 100 is controlled (by the switch controller 110) to be non-conducting. As a result, regardless of the voltage level at the external pin 102, the external pin 102 is always electrically disconnected from the internal circuitry 104. In addition, the clamp cell 114 is configured to clamp the abnormally high voltage level (due to the ESD event) associated with the first voltage supply V1 to a safe level for the LDO 112, and the LDO 112 is activated and configured to provide the protected/safe voltage V_{P} to power the internal circuitry 104.

When the first voltage supply V1 is stably present without associating with any ESD event, the protection switch 108 of the ESD protection block 100 is controlled (by the switch controller 110) to be either conducting or non-conducting based on the transient voltage level presented at the external pin 102. In addition, when the first voltage supply V1 is stably present, the LDO 112 is activated and configured to provide the protected/safe voltage V_{P} to power the internal circuitry 104. When the first voltage supply V1 is stably present and an ESD event occurs at the external pin 112 (e.g., a transient voltage level presented at the external pin 102 exceeds the breakdown voltage of the thin-oxide MOS transistors), the switch controller 110 is configured to make the protection switch 108 non-conducting (i.e., the protection switch 108 is open). As a result, the abnormally high transient voltage level presented at the external pin 102 will not reach the internal circuitry 104. In addition, in some scenarios where the transient voltage level presented at the external pin 102 exceeds the breakdown voltage of the protection switch 108 or the switch controller 110, the ESD clamp cell 106 is configured to clamp the abnormally high transient voltage level presented at the external pin 102 to a safe level for the protection switch 108 and the switch controller 110. As a result, the ESD event occurring at the external pin 102 will not damage the protection switch 108 or the switch controller 110. Furthermore, when the first voltage supply V1 is stably present and no ESD event occurs at the external supply pin 102, the switch controller 110 is configured to make the protection switch 108 conducting (i.e., the protection switch 108 is closed). As a result, the external pin 102 as well as the stabilizing capacitor C1 is electrically connected to the output of the LDO 112, and the safe voltage supply V_{P}, which is provided at the output of the LDO 112 to power the internal circuitry 104, is stabilized.

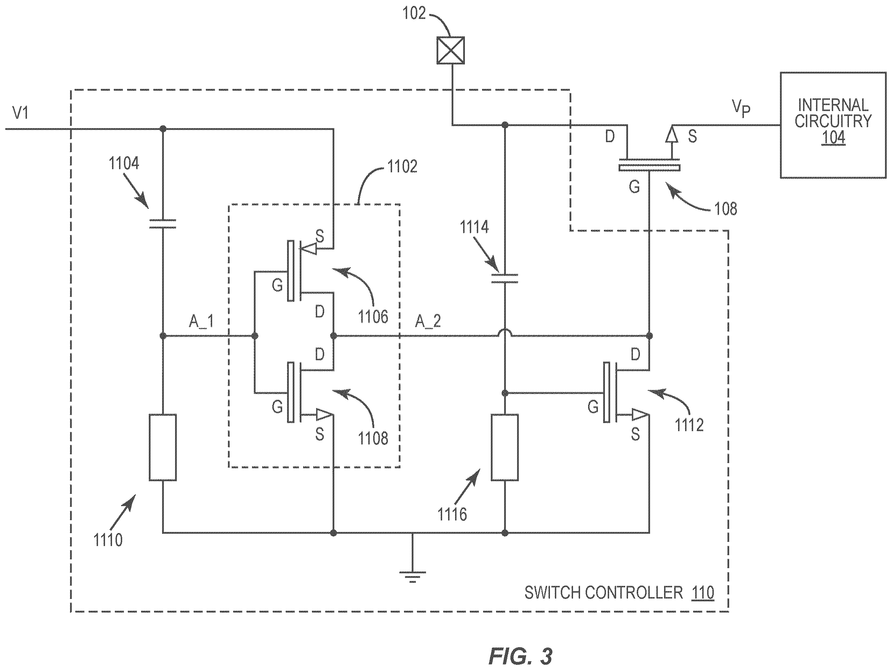

In some embodiments, each of the ESD clamp cell 106 and the clamp cell 114 may be implemented by a Zener diode or a typical RC-based power-rail ESD clamp circuit with multiple MOS transistors, and is fabricated with thick oxide, rather than the thin oxide as used in the thin-oxide MOS transistors within the internal circuitry 104. Figure 3 illustrates an example implementation of the switch controller 110. Herein, the switch controller 110 includes an inverter 1102 coupled between the first voltage supply V1 and ground, and an input terminal A_1 of the inverter 1102 is coupled to the first voltage supply V1 through a first capacitor 1104. For the purpose of this illustration, the inverter 1102 may be implemented by a first transistor 1106 and a second transistor 1108, where the first transistor 1106 is a P-type MOS transistor, and the second transistor 1108 is an N-type MOS transistor. A source of the first transistor 1106 is coupled to the first voltage supply V1, a gate of the first transistor 1106 is coupled to a gate of the second transistor 1108 forming the input terminal A_1 of the inverter 1102, a drain of the first transistor 1106 is coupled to a drain of the second transistor 1108 forming an output terminal A_2 of the inverter 1102, and a source of the second transistor 1108 is coupled to ground. The input terminal A_1 of the inverter 1102 may also be coupled to ground through a first resistor 1110 (i.e., the first capacitor 1104 and the first resistor 1110 are coupled in series between the first voltage supply V1 and ground, and the input terminal A_1 of the inverter 1102 is coupled to a joint point of the first capacitor 1104 and the first resistor 1110). In different applications, the inverter 1102 may be implemented in other configurations, and the first resistor 1110 might be omitted or replaced by other resistance structures.

In addition, the switch controller 110 also includes a control switch 1112 coupled between the protection switch 108 and ground. For the purpose of this illustration, each of the protection switch 108 and the control switch 1112 may be implemented by an N-type MOS transistor (herein and hereafter, the protection switch 108 and the protection transistor 108 refer to a same electronic component, and the control switch 1112 and the control transistor 1112 refer to a same electronic component). A drain of the protection transistor 108 is coupled to the external pin 102, a source of the protection transistor 108 is coupled to the internal circuitry 104, and a gate of the protection transistor 108 (i.e., a controlling terminal of the protection switch 1108) is coupled to a drain of the control transistor 1112 and coupled to the output terminal of the inverter 1102. A source of the control transistor 1112 is coupled to ground, and a gate of the control transistor 1112 (i.e., a controlling terminal of the control switch 1112) is coupled to the external pin 102 through a second capacitor 1114. The gate of the control transistor 1112 may also be coupled to ground through a second resistor 1116 (i.e., the second capacitor 1114 and the second resistor 1116 are coupled in series between the external pin 102 and ground, and the gate of the control transistor 1112 is coupled to a joint point of the second capacitor 1114 and the second resistor 1116). In different applications, the protection switch 108 and the control switch 1112 may be implemented in other configurations. The second resistor 1116 might be omitted or replaced by other resistance structures.

The first transistor 1106, the second transistor 1108, and the control transistor 1112 are fabricated with thick oxide, rather than thin oxide as used in the thin-oxide MOS transistors within the internal circuitry 104. As such, the first voltage supply V1 applied to these transistors 1106, 1108 and 1112 can be larger than the voltage input V_{P} applied to the internal circuitry 104. When the first voltage supply V1 is absent, the inverter 1102 is inactive, and a voltage level at the output terminal A_2 of the inverter 1102 is low (e.g., ground). Regardless of whether an ESD event occurs at the external pin 102 or not and/or the control transistor 1112 is conducting or non-conducting, a voltage level applied to the gate of the protection transistor 108 is low. As such, the protection transistor 108 is always non-conducting, and thereby electrically disconnects the internal circuitry 104 from the external pin 102.

During a short power-on transient stage of the first voltage supply V1, the first capacitor 1104 will pull a voltage level at the input terminal A_1 of the inverter 1102 high. It is because a voltage across the first capacitor 1104 cannot change immediately. There is a time constant of the first capacitor 1104 indicating how fast the first capacitor 1104 charges or discharges to change the voltage across the first capacitor 1104. The first resistor 1110 may be configured to tune the time constant of the first capacitor 1104. Once the voltage level at the input terminal A_1 of the inverter 1102 is high, the voltage level at the output terminal A_2 of the inverter 1102 is low (e.g., ground). Regardless of whether an ESD event occurs at the external pin 102 or not and/or the control transistor 1112 is conducting or non-conducting, a voltage level applied to the gate of the protection transistor 108 is low. As such, the protection transistor 108 is always non-conducting, and thereby electrically disconnects the internal circuitry 104 from the external pin 102. Herein, the first capacitor 1104 assures that if a sudden voltage jump occurs on the first voltage supply V1, the protection switch 108 is made non-conducting.

When an ESD event occurs in association with the first voltage supply V1 (i.e., a sudden voltage jump of the first voltage supply), the first capacitor 1104 will pull a voltage level at the input terminal A_1 of the inverter 1102 high. It is because a voltage across the first capacitor 1104 cannot change immediately. There is a time constant of the first capacitor 1104 indicating how fast the first capacitor 1104 charges or discharges to change the voltage across the first capacitor 1104. The first resistor 1110 may be configured to tune the time constant of the first capacitor 1104. Once the voltage level at the input terminal A_1 of the inverter 1102 is high, the voltage level at the output terminal A_2 of the inverter 1102 is low (e.g., ground). Regardless of whether an ESD event occurs at the external pin 102 or not and/or the control transistor 1112 is conducting or non-conducting, a voltage level applied to the gate of the protection transistor 108 is low. As such, the protection transistor 108 is always non-conducting, and thereby electrically disconnects the internal circuitry 104 from the external pin 102. Herein, the first capacitor 1104 assures that if an ESD event occurs in association with the first voltage supply V1, the protection switch 108 is made non-conducting.

When the first voltage supply V1 is stably present, the voltage level at the input terminal A_1 of the inverter 1102 is low (since most of the first voltage supply V1 is across the first capacitor 1104), and the output terminal A_2 of the inverter 1102 will be high. Herein, if an ESD event occurs at the external pin 102 (i.e., a sudden high voltage is present at the external pin 102), the second capacitor 1114 will pull a voltage level at the gate of the control transistor 1112 high (since a voltage across the second capacitor 1114 cannot change immediately as described above). The second resistor 1116 may be configured to tune a time constant of the second capacitor 1114. The high voltage level at the gate of the control transistor 1112 makes the control transistor 1112 conduct to ground. Herein, the control transistor 1112 is larger than the first transistor 1106. As a result, the output terminal A_2 of the inverter 1102 as well as the gate of the protection transistor 108 are pulled to a low voltage level through the control transistor 1112, which conducts to ground. When the first voltage supply V1 is stably present and no ESD event occurs at the external pin 102 (i.e., no sudden high voltage is present at the external pin 102), the voltage level at the gate of the control transistor 1112 is low, and the control transistor 1112 is non-conducting. Consequently, the high voltage level at the output terminal of the inverter 1102 will apply to the gate of the protection transistor 108, the protection transistor 108 will be conducting, and the external pin 102 will be electrically connected to the internal circuitry 104. For non-limiting examples, the internal circuitry 104 may receive the voltage input from the external pin 102, or electronic components outside the electrical device 10 coupled to the external pin 102 may stabilize the voltage applied to the internal circuitry 104.

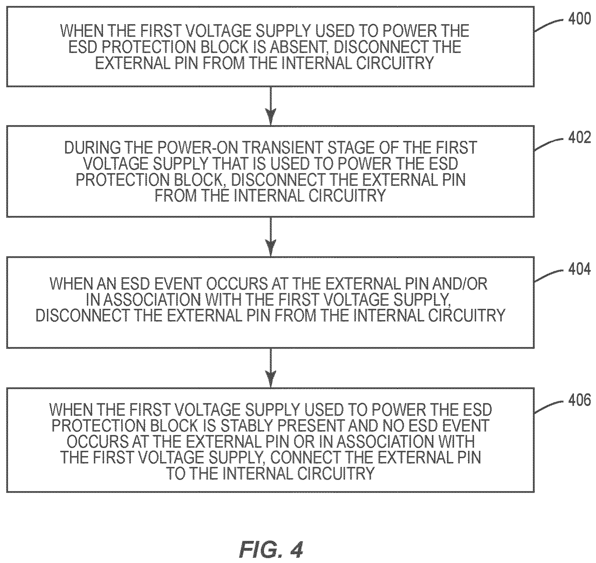

Figure 4 illustrates a flowchart of operations of the ESD protection block 100 to protect thin-oxide MOS transistors within the internal circuitry 104 during an ESD event and/or a power-on transient stage according to some embodiments of the present disclosure. Although the process steps are illustrated in a series, the process steps are not necessarily order dependent. Some steps may be done in a different order than that presented. Further, processes within the scope of this disclosure may include fewer or more steps than those illustrated in Figure 4. When the first voltage supply V1 used to power the ESD protection block 100 is absent, the external pin 102 is disconnected from the internal circuitry 104 by opening the protection switch 108 coupled between the external pin 102 and the internal circuitry 104 (step 400). In addition, during the power-on transient stage of the first voltage supply V1 that is used to power the ESD protection block 100, the external pin 102 is disconnected from the internal circuitry 104 by opening the protection switch 108 coupled between the external pin 102 and the internal circuitry 104 (step 402). When an ESD event occurs at the external pin and/or in association with the first voltage supply V1, the external pin 102 is disconnected from the internal circuitry 104 by opening the protection switch 108 coupled between the external pin 102 and the internal circuitry 104 (step 404). When the first voltage supply V1 used to power the ESD protection block 100 is stably present and no ESD event occurs at the external pin 102 or in association with the first voltage supply, the external pin 102 is connected to the internal circuitry 104 by closing the protection switch 108 coupled between the external pin 102 and the internal circuitry 104 (step 406). Herein, the opening or closing of the protection switch 108 is controlled by the switch controller 110 based on both the status of the first voltage supply V1 and the presence of the ESD event at the external pin 102.

Therefore from one perspective, there have been described approaches for electrostatic discharge (ESD) protection circuitry of an electronic device, which is capable of protecting thin-oxide metal-oxide-semiconductor (MOS) transistors within the electronic device during an ESD event and/or a power-on transient stage without large current leakage. The disclosed ESD protection circuitry at least includes a protection switch and a switch controller. The protection switch is coupled between an external pin of the electronic device and internal circuitry of the electronic device, which is composed of thin-oxide MOS transistors. The switch controller is configured to control the protection switch to be conducting or non-conducting based on both a status of a first voltage supply powering the ESD protection block and a presence of an ESD event at the external pin, such that the external pin is electrically connected to or disconnected from the internal circuitry.

Further examples of feature combinations taught by the present disclosure are set out in the following numbered clauses.

Clause 1. An electrostatic discharge (ESD) protection block of an electronic device comprising: a protection switch coupled between an external pin of the electronic device and internal circuitry of the electronic device; and a switch controller configured to control the protection switch to be conducting or non-conducting based on both a status of a first voltage supply powering the ESD protection block and a presence of an ESD event at the external pin, wherein: the internal circuitry has a lower breakdown voltage than that of the protection switch and the switch controller; the switch controller is configured to control the protection switch to be non-conducting when the first voltage supply is absent, when the first voltage supply is in a power-on transient stage, or when an ESD event occurs at the external pin and/or in association with the first voltage supply, such that the external pin is electrically disconnected from the internal circuitry; and the switch controller is configured to control the protection switch to be conducting when the first voltage supply powering the ESD protection block is stably present and no ESD event occurs at the external pin or in association with the first voltage supply, such that the external pin is electrically connected to the internal circuitry.

Clause 2. The ESD protection block of clause 1, wherein: the internal circuitry includes a plurality of thin-oxide metal-oxide-semiconductor (MOS) transistors; and the protection switch and the switch controller are fabricated with thick oxide, rather than thin oxide as used in the plurality of thin-oxide MOS transistors within the internal circuitry.

Clause 3. The ESD protection block of clause 1 or 2, further comprising an ESD clamp cell, which is coupled between the external pin and ground and before the protection switch and the switch controller, wherein the ESD clamp cell is configured to limit a voltage level at the external pin below the breakdown voltage of the protection switch and the switch controller.

Clause 4. The ESD protection block of clause 3, wherein: the internal circuitry includes a plurality of thin-oxide MOS transistors; and the ESD clamp cell, the protection switch, and the switch controller are fabricated with thick oxide, rather than thin oxide as used in the plurality of thin-oxide MOS transistors within the internal circuitry.

Clause 5. The ESD protection block of clause 4, wherein: the protection switch is implemented by a protection transistor that is an N-type MOS transistor; and a drain of the protection transistor is coupled to the external pin, a source of the protection transistor is coupled to the internal circuitry, and a gate of the protection transistor is controlled by the switch controller.

Clause 6. The ESD protection block of clause 5, wherein: the switch controller includes an inverter, a first capacitor, a control switch, and a second capacitor; the inverter is coupled between the first voltage supply powering the ESD protection block and ground, and the first capacitor is coupled between the first voltage supply and an input terminal of the inverter; the control switch is coupled between the gate of the protection transistor and ground; an output terminal of the inverter is coupled to the gate of the protection transistor; and the second capacitor is coupled between the external pin and a controlling terminal of the control switch.

Clause 7. The ESD protection block of clause 6, wherein: the inverter is implemented by a first transistor and a second transistor, wherein the first transistor is a P-type MOS transistor, and the second transistor is an N-type MOS transistor; a source of the first transistor is coupled to the first voltage supply, a gate of the first transistor is coupled to a gate of the second transistor forming the input terminal of the inverter, a drain of the first transistor is coupled to a drain of the second transistor forming the output terminal of the inverter, and a source of the second transistor is coupled to ground; the control switch is implemented by a control transistor that is an N-type MOS transistor; and a drain of the control transistor is coupled to the gate of the protection transistor, a source of the control transistor is coupled to ground, and a gate of the control transistor is coupled to the external pin through the second capacitor.

Clause 8. The ESD protection block of clause 7, wherein: the first transistor, the second transistor, the control transistor, and the protection transistor are fabricated with thick oxide, rather than thin oxide as used in the thin-oxide MOS transistors within the internal circuitry; and the first voltage supply powering the ESD protection block is larger than a voltage input applied to the internal circuitry.

Clause 9. The ESD protection block of clause 7 or 8, wherein the control transistor is larger than the first transistor of the inverter.

Clause 10. The ESD protection block of clause 9, wherein: when the first voltage supply is absent, the inverter is inactive, and a voltage level at the output terminal of the inverter is low, wherein regardless of whether an ESD event occurs at the external pin or not, the protection transistor is non-conducting, and thereby electrically disconnects the internal circuitry from the external pin; during the short power-on transient stage of the first voltage supply or when an ESD event occurs in association with the first voltage supply, the first capacitor pulls a voltage level at the input terminal of the inverter high, which causes the voltage level at the output terminal of the inverter to be low, wherein regardless of whether an ESD event occurs at the external pin or not, the protection transistor is non-conducting, and thereby electrically disconnects the internal circuitry from the external pin; when the first voltage supply is stably present and an ESD event occurs at the external pin, the second capacitor pulls a voltage level at the gate of the control transistor high, which makes the control transistor conduct to ground, wherein, the output terminal of the inverter and the gate of the protection transistor are pulled to a low voltage level through the conducting control transistor, which is larger than the first transistor of the inverter; and when the first voltage supply is stably present and no ESD event occurs at the external pin, the control transistor is non-conducting, and the voltage level of the output terminal of the inverter is high, such that the protection transistor is conducting, and the external pin is electrically connected to the internal circuitry.

Clause 11. The ESD protection block of any of clauses 7 to 10, wherein: the switch controller further includes a first resistor and a second resistor; and the first resistor is coupled between the input terminal of the inverter and ground, and the second resistor is coupled between the gate of the control transistor and ground.

Clause 12. An electronic device comprising: an external pin; internal circuitry; and an electrostatic discharge (ESD) protection block coupled between the external pin and the internal circuitry, wherein: the internal circuitry includes a plurality of thin-oxide MOS transistors, and the ESD protection block is fabricated with thick oxide, rather than thin oxide as used in the plurality of thin-oxide MOS transistors within the internal circuitry, such that the internal circuitry has a lower breakdown voltage than that of the ESD protection block; the ESD protection block is configured to connect the external pin to or disconnect the external pin from the internal circuitry based on both a status of a first voltage supply powering the ESD protection block and a presence of an ESD event at the external pin; the external pin is disconnected from the internal circuitry when the first voltage supply is absent, when an ESD event occurs at the external pin and/or in association with the first voltage supply; and the external pin is connected to the internal circuitry when the first voltage supply powering the ESD protection block is stably present and no ESD event occurs at the external pin or in association with the first voltage supply.

Clause 13. The electronic device of clause 12 wherein: the ESD protection block comprises a protection switch coupled between the external pin and the internal circuitry, and a switch controller configured to control the protection switch to be conducting or non-conducting based on both the status of the first voltage supply powering the ESD protection block and the presence of an ESD event at the external pin; the switch controller is configured to control the protection switch to be non-conducting when the first voltage supply is absent, when the first voltage supply is in a power-on transient stage, or when an ESD event occurs at the external pin and/or in association with the first voltage supply, such that the external pin is disconnected from the internal circuitry; and the switch controller is configured to control the protection switch to be conducting when the first voltage supply powering the ESD protection block is stably present and no ESD event occurs at the external pin or in association with the first voltage supply, such that the external pin is connected to the internal circuitry.

Clause 14. The electronic device of clause 13 wherein the ESD protection block further comprises an ESD clamp cell, which is coupled between the external pin and ground and before the protection switch and the switch controller, wherein the ESD clamp cell is configured to limit a voltage level at the external pin below a breakdown voltage of the protection switch and the switch controller.

Clause 15. The electronic device of clause 12, 13 or 14, wherein the external pin is configured to provide a second voltage supply for the electronic device to power the internal circuitry, and the second voltage supply is lower than the first voltage supply powering the ESD protection block.

Clause 16. The electronic device of any of clauses 12 to 15, wherein the external pin is configured to provide a logic input signal for the internal circuitry, and the logic input signal for the internal circuitry is lower than the first voltage supply powering the ESD protection block.

Clause 17. The electronic device of any of clauses 12 to 16, further includes a low dropout regulator (LDO), wherein the LDO is coupled between the first voltage supply and the internal circuitry, and the internal circuitry is powered by a regulated version of the first voltage supply provided through the LDO.

Clause 18. The electronic device of clause 17 further includes a clamp cell coupled between the first voltage supply and ground and before the LDO, wherein the clamp cell is configured to clamp a voltage level applied to the LDO below a breakdown voltage of the LDO during the power-on transient stage of the first voltage supply.

Clause 19. The electronic device of clause 18 wherein the LDO and the clamp cell are fabricated with thick oxide, rather than thin oxide as used in the plurality of thin-oxide MOS transistors within the internal circuitry, such that the internal circuitry has a lower breakdown voltage than that of the LDO and the clamp cell.

Clause 20. A method of operations of an electrostatic discharge (ESD) protection block of an electronic device for protecting thin-oxide metal-oxide-semiconductor (MOS) transistors within internal circuitry of the electronic device, the ESD protection block including a switch controller and a protection switch coupled between an external pin of the electronic device and the internal circuitry, the method comprising: disconnecting the external pin from the internal circuitry by opening the protection switch when a first voltage supply powering the ESD protection block is absent; disconnecting the external pin from the internal circuitry by opening the protection switch during a power-on transient stage of the first voltage supply powering the ESD protection block; disconnecting the external pin from the internal circuitry by opening the protection switch when an ESD event occurs at the external pin and or in association with the first voltage supply; and connecting the external pin to the internal circuitry by closing the protection switch when the first voltage supply powering the ESD protection block is stably present and no ESD event occurs at the external pin or in association with the first voltage supply, wherein: the opening or closing of the protection switch is controlled by the switch controller based on both a status of the first voltage supply and a presence of the ESD event at the external pin; andthe thin-oxide MOS transistors within internal circuitry have a lower breakdown voltage than that of the protection switch and the switch controller.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the described embodiments of the present disclosure. All such improvements and modifications are considered within the scope of the concepts disclosed herein and the claims that follow.

## Claims

1. An electrostatic discharge (ESD) protection block of an electronic device comprising:
• a protection switch coupled between an external pin of the electronic device and internal circuitry of the electronic device; and
• a switch controller configured to control the protection switch to be conducting or non-conducting based on both a status of a first voltage supply powering the ESD protection block and a presence of an ESD event at the external pin, wherein:
• the internal circuitry has a lower breakdown voltage than that of the protection switch and the switch controller;
• the switch controller is configured to control the protection switch to be non-conducting when the first voltage supply is absent, when the first voltage supply is in a power-on transient stage, or when an ESD event occurs at the external pin and/or in association with the first voltage supply, such that the external pin is electrically disconnected from the internal circuitry; and
• the switch controller is configured to control the protection switch to be conducting when the first voltage supply powering the ESD protection block is stably present and no ESD event occurs at the external pin or in association with the first voltage supply, such that the external pin is electrically connected to the internal circuitry.

2. The ESD protection block of claim 1, wherein:
• the internal circuitry includes a plurality of thin-oxide metal-oxide-semiconductor (MOS) transistors; and
• the protection switch and the switch controller are fabricated with thick oxide, rather than thin oxide as used in the plurality of thin-oxide MOS transistors within the internal circuitry.

3. The ESD protection block of claim 1 or 2, further comprising an ESD clamp cell, which is coupled between the external pin and ground and before the protection switch and the switch controller, wherein the ESD clamp cell is configured to limit a voltage level at the external pin below the breakdown voltage of the protection switch and the switch controller.

4. The ESD protection block of claim 3, wherein:
• the internal circuitry includes a plurality of thin-oxide MOS transistors; and
• the ESD clamp cell, the protection switch, and the switch controller are fabricated with thick oxide, rather than thin oxide as used in the plurality of thin-oxide MOS transistors within the internal circuitry.

5. The ESD protection block of claim 4, wherein:
• the protection switch is implemented by a protection transistor that is an N-type MOS transistor; and
• a drain of the protection transistor is coupled to the external pin, a source of the protection transistor is coupled to the internal circuitry, and a gate of the protection transistor is controlled by the switch controller.

6. The ESD protection block of claim 5, wherein:
• the switch controller includes an inverter, a first capacitor, a control switch, and a second capacitor;
• the inverter is coupled between the first voltage supply powering the ESD protection block and ground, and the first capacitor is coupled between the first voltage supply and an input terminal of the inverter;
• the control switch is coupled between the gate of the protection transistor and ground;
• an output terminal of the inverter is coupled to the gate of the protection transistor; and
• the second capacitor is coupled between the external pin and a controlling terminal of the control switch.

7. The ESD protection block of claim 6, wherein:
• the inverter is implemented by a first transistor and a second transistor, wherein the first transistor is a P-type MOS transistor, and the second transistor is an N-type MOS transistor;
• a source of the first transistor is coupled to the first voltage supply, a gate of the first transistor is coupled to a gate of the second transistor forming the input terminal of the inverter, a drain of the first transistor is coupled to a drain of the second transistor forming the output terminal of the inverter, and a source of the second transistor is coupled to ground;
• the control switch is implemented by a control transistor that is an N-type MOS transistor; and
• a drain of the control transistor is coupled to the gate of the protection transistor, a source of the control transistor is coupled to ground, and a gate of the control transistor is coupled to the external pin through the second capacitor.

8. The ESD protection block of claim 7, wherein:
• the first transistor, the second transistor, the control transistor, and the protection transistor are fabricated with thick oxide, rather than thin oxide as used in the thin-oxide MOS transistors within the internal circuitry; and
• the first voltage supply powering the ESD protection block is larger than a voltage input applied to the internal circuitry.

9. The ESD protection block of claim 7 or 8, wherein the control transistor is larger than the first transistor of the inverter.

10. The ESD protection block of claim 9, wherein:
• when the first voltage supply is absent, the inverter is inactive, and a voltage level at the output terminal of the inverter is low, wherein regardless of whether an ESD event occurs at the external pin or not, the protection transistor is non-conducting, and thereby electrically disconnects the internal circuitry from the external pin;
• during the short power-on transient stage of the first voltage supply or when an ESD event occurs in association with the first voltage supply, the first capacitor pulls a voltage level at the input terminal of the inverter high, which causes the voltage level at the output terminal of the inverter to be low, wherein regardless of whether an ESD event occurs at the external pin or not, the protection transistor is non-conducting, and thereby electrically disconnects the internal circuitry from the external pin;
• when the first voltage supply is stably present and an ESD event occurs at the external pin, the second capacitor pulls a voltage level at the gate of the control transistor high, which makes the control transistor conduct to ground, wherein, the output terminal of the inverter and the gate of the protection transistor are pulled to a low voltage level through the conducting control transistor, which is larger than the first transistor of the inverter; and
• when the first voltage supply is stably present and no ESD event occurs at the external pin, the control transistor is non-conducting, and the voltage level of the output terminal of the inverter is high, such that the protection transistor is conducting, and the external pin is electrically connected to the internal circuitry.

11. The ESD protection block of any of claims 7 to 10, wherein:
• the switch controller further includes a first resistor and a second resistor; and
• the first resistor is coupled between the input terminal of the inverter and ground, and the second resistor is coupled between the gate of the control transistor and ground.

12. An electronic device comprising:
• an external pin;
• internal circuitry; and
• an electrostatic discharge (ESD) protection block coupled between the external pin and the internal circuitry, wherein:
• the internal circuitry includes a plurality of thin-oxide MOS transistors, and the ESD protection block is fabricated with thick oxide, rather than thin oxide as used in the plurality of thin-oxide MOS transistors within the internal circuitry, such that the internal circuitry has a lower breakdown voltage than that of the ESD protection block;
• the ESD protection block is configured to connect the external pin to or disconnect the external pin from the internal circuitry based on both a status of a first voltage supply powering the ESD protection block and a presence of an ESD event at the external pin;
• the external pin is disconnected from the internal circuitry when the first voltage supply is absent, when an ESD event occurs at the external pin and/or in association with the first voltage supply; and
• the external pin is connected to the internal circuitry when the first voltage supply powering the ESD protection block is stably present and no ESD event occurs at the external pin or in association with the first voltage supply.

13. The electronic device of claim 12 wherein:
• the ESD protection block comprises a protection switch coupled between the external pin and the internal circuitry, and a switch controller configured to control the protection switch to be conducting or non-conducting based on both the status of the first voltage supply powering the ESD protection block and the presence of an ESD event at the external pin;
• the switch controller is configured to control the protection switch to be non-conducting when the first voltage supply is absent, when the first voltage supply is in a power-on transient stage, or when an ESD event occurs at the external pin and/or in association with the first voltage supply, such that the external pin is disconnected from the internal circuitry; and
• the switch controller is configured to control the protection switch to be conducting when the first voltage supply powering the ESD protection block is stably present and no ESD event occurs at the external pin or in association with the first voltage supply, such that the external pin is connected to the internal circuitry.

14. The electronic device of claim 13 wherein the ESD protection block further comprises an ESD clamp cell, which is coupled between the external pin and ground and before the protection switch and the switch controller, wherein the ESD clamp cell is configured to limit a voltage level at the external pin below a breakdown voltage of the protection switch and the switch controller.

15. The electronic device of claim 12, 13 or 14, wherein the external pin is configured to provide a second voltage supply for the electronic device to power the internal circuitry, and the second voltage supply is lower than the first voltage supply powering the ESD protection block.

16. The electronic device of any of claims 12 to 15, wherein the external pin is configured to provide a logic input signal for the internal circuitry, and the logic input signal for the internal circuitry is lower than the first voltage supply powering the ESD protection block.

17. The electronic device of any of claims 12 to 15, further includes a low dropout regulator (LDO), wherein the LDO is coupled between the first voltage supply and the internal circuitry, and the internal circuitry is powered by a regulated version of the first voltage supply provided through the LDO.

18. The electronic device of claim 17 further includes a clamp cell coupled between the first voltage supply and ground and before the LDO, wherein the clamp cell is configured to clamp a voltage level applied to the LDO below a breakdown voltage of the LDO during the power-on transient stage of the first voltage supply.

19. The electronic device of claim 18 wherein the LDO and the clamp cell are fabricated with thick oxide, rather than thin oxide as used in the plurality of thin-oxide MOS transistors within the internal circuitry, such that the internal circuitry has a lower breakdown voltage than that of the LDO and the clamp cell.

20. A method of operations of an electrostatic discharge (ESD) protection block of an electronic device for protecting thin-oxide metal-oxide-semiconductor (MOS) transistors within internal circuitry of the electronic device, the ESD protection block including a switch controller and a protection switch coupled between an external pin of the electronic device and the internal circuitry, the method comprising:
• disconnecting the external pin from the internal circuitry by opening the protection switch when a first voltage supply powering the ESD protection block is absent;
• disconnecting the external pin from the internal circuitry by opening the protection switch during a power-on transient stage of the first voltage supply powering the ESD protection block;
• disconnecting the external pin from the internal circuitry by opening the protection switch when an ESD event occurs at the external pin and or in association with the first voltage supply; and
• connecting the external pin to the internal circuitry by closing the protection switch when the first voltage supply powering the ESD protection block is stably present and no ESD event occurs at the external pin or in association with the first voltage supply, wherein:
• the opening or closing of the protection switch is controlled by the switch controller based on both a status of the first voltage supply and a presence of the ESD event at the external pin; and
• the thin-oxide MOS transistors within internal circuitry have a lower breakdown voltage than that of the protection switch and the switch controller.
